# EUROPÄISCHE PATENTSCHRIFT

(11) **EP 3 750 237 B1**
(45) Veröffentlichungstag und Bekanntmachung des Hinweises auf die Patenterteilung: **30.08.2023**
(21) Anmeldenummer: 19712125.4
(22) Anmeldetag: 08.02.2019
(51) Int. Cl.: H02S 50/10

(54) **VORRICHTUNG ZUR ELEKTRISCHEN KONTAKTIERUNG EINER SOLARZELLE BEI DER MESSUNG ELEKTRISCHER KENNDATEN DER SOLARZELLE UND VERFAHREN ZUR MESSUNG ELEKTRISCHER KENNDATEN EINER SOLARZELLE**
DEVICE FOR ELECTRICALLY CONTACTING A SOLAR CELL DURING THE MEASUREMENT OF ELECTRICAL CHARACTERISTICS OF THE SOLAR CELL, AND METHOD FOR MEASURING ELECTRICAL CHARACTERISTICS OF A SOLAR CELL
DISPOSITIF DE MISE EN CONTACT ÉLECTRIQUE D'UNE CELLULE SOLAIRE LORS DE LA MESURE DE CARACTÉRISTIQUES ÉLECTRIQUES DE LA CELLULE SOLAIRE ET PROCÉDÉ DE MESURE DE CARACTÉRISTIQUES ÉLECTRIQUES D'UNE CELLULE SOLAIRE

(30) Priorität: 08.02.2018 DE 102018102840
(43) Veröffentlichungstag der Anmeldung: 16.12.2020
(73) Patentinhaber: Wavelabs Solar Metrology Systems GmbH, 04179 Leipzig (DE)
(72) Erfinder: ESEFELDER, Sascha, 04229 Leipzig (DE); WILDGRUBE, Falk, 04229 Leipzig (DE); BRAMMER, Torsten, 04229 Leipzig (DE); ZEMITZSCH, Wolfgang, 04277 Leipzig (DE)
(74) Vertreter: adares Patent- und Rechtsanwälte Reininger & Partner GmbB
(86) Internationale Anmeldenummer: PCT/DE2019/100126
(87) Internationale Veröffentlichungsnummer: WO 2019/154464

(56) Entgegenhaltungen:
- WO-A1-2012/095275
- WO-A1-2012/127411

## Beschreibung

Die Erfindung betrifft eine Vorrichtung zur elektrischen Kontaktierung einer Solarzelle bei der Messung elektrischer Kenndaten der Solarzelle und ein Verfahren zur Messung elektrischer Kenndaten einer Solarzelle. Insbesondere betrifft die Erfindung eine Vorrichtung und ein Verfahren zur Messung der elektrischen Kenndaten der Solarzelle, wobei die Solarzelle mit einer Vielzahl von Fingerelektroden auf einer Solarzellenoberfläche ausgebildet ist, aber keinen Busbar aufweist.

In der US2007/0068567A1 ist eine Vorrichtung zur elektrischen Kontaktierung einer Solarzelle bei der Messung elektrischer Kenndaten der Solarzelle beschrieben, die zwei Messleisten aufweist, die sich zwischen zwei Messleisten-Endabschnitten in einer Messleisten-Erstreckungsrichtung erstrecken, wobei jede Messleiste mindestens einen Kontaktanschluss zur elektrischen Kontaktierung mit einer Solarzellentestvorrichtung aufweist. Die Vorrichtung weist ferner eine Mehrzahl Kontaktfederabschnitte auf, die entlang der Messleisten-Erstreckungsrichtung an jeder Messleiste angeordnet sind, wobei jeder Kontaktfederabschnitt ausgebildet ist, beim Aufsetzen der Messleiste auf die Solarzellenoberfläche, mit der Messleisten-Erstreckungsrichtung quer zu den Fingerelektroden orientiert mindestens eine Fingerelektrode durch einen federelastischen mechanischen Kontakt elektrisch zu kontaktieren. Zur Messung elektrischer Kenndaten der Solarzelle wird die Solarzelle in der Vorrichtung gehalten, wobei die Kontaktfederabschnitte auf die Fingerelektroden der Solarzelle gedrückt werden. Die Solarzellenoberfläche wird Licht ausgesetzt, so dass der generierte Photostrom durch die Fingerelektroden der Solarzelle fließt, welcher über die in elektrischem Kontakt mit den Fingerelektroden stehenden Kontaktfederabschnitte und die Messleisten gesammelt und vermessen wird. Die Kontaktfederabschnitte sind als langgestreckte elastische Elemente, beispielsweise als flexibles Metalldraht-Maschenmaterial oder als metallische hohlzylinderförmige Elemente ausgebildet. Ein Problem dieser aus dem Stand der Technik bekannten Vorrichtung besteht darin, dass die Messleisten die Solarzellenoberfläche quer zu ihrer Messleisten-Erstreckungsrichtung betrachtet relativ breit abschatten. Die dadurch generierte Abschattung der Messleisten ist oftmals deutlich größer als die durch Zellverbinder im Solarmodul generierte Abschattung, so dass die durchgeführte Messung wenig realitätsnah ist. An den Übergängen zwischen Kontaktfederabschnitten und Messleiste können aufgrund elektrochemisch unterschiedlicher Werkstoffe zusätzliche Kontaktwiderstände und/oder Kontaktpotentiale auftreten, die die Messergebnisse beeinflussen. Zudem besteht weiterhin Bedarf an einer gleichzeitig kostengünstigeren Lösung für eine verbesserte Vorrichtung und ein damit durchgeführtes optimiertes Messverfahren.

Weiterhin ist aus der WO 2012/095275 A1 eine Vorrichtung zur elektrischen Kontaktierung einer Solarzelle bei der Messung elektrischer Kenndaten der Solarzelle beschrieben, die eine Messleiste mit einer Stromsammelschiene aufweist, an der eine Mehrzahl von in Richtung des herzustellenden Kontakts federnde Kontaktfinger angeordnet ist.

Aus der WO 2012/127411 A1 ist ferner eine Vorrichtung zur elektrischen Kontaktierung einer Solarzelle bei der Messung elektrischer Kenndaten der Solarzelle beschrieben, die eine Messleiste mit einer Vielzahl von Kontaktelementen aufweist, die sich in Richtung eines Busbars einer Solarzelle erstrecken, um ihn elektrisch kontaktieren zu können. Die Vorrichtung kann weiterhin eine Vielzahl von Aufhängeeinheiten aufweisen, die die Messleiste halten. Die Aufhängeeinheiten weisen jeweils Halteelemente und Horizontalelemente auf, die die Haltelemente mit der Messleiste verbinden, so dass die Horizontalelemente eine vertikale Bewegung der Messleiste in Bezug auf die Aufhängeeinheiten und eine vertikale Translation der Halteelemente erlauben, aber alle anderen Translationsbewegungen der Halteelemente blockieren. Dadurch verhindern die Horizontalelemente, dass eine zu große Kraft auf die Solarzelle ausgeübt und diese zerstört wird.

Ferner ist aus der EP 2 875 366 A1 eine Testvorrichtung zum Testen einer Solarzelle bekannt, die mindestens einen flexiblen Draht und Druckmittel zum Andrücken des Drahts entlang seiner Erstreckungsrichtung auf einen elektrischen Kontakt einer Wafer-Solarzelle aufweist. Das Druckmittel weist zwei Halteelemente auf, die den Draht zur elektrischen Kontaktierung mit dem elektrischen Kontakt der Solarzelle fixieren.

Die Aufgabe der Erfindung besteht darin, eine Vorrichtung zur elektrischen Kontaktierung einer Solarzelle bei der Messung elektrischer Kenndaten der Solarzelle und ein Verfahren zur Messung elektrischer Kenndaten einer Solarzelle bereitzustellen, die eine realitätsnähere Messung ermöglicht und gleichzeitig kostengünstiger ist.

Die Aufgabe der Erfindung wird durch eine Vorrichtung mit den Merkmalen des Patentanspruchs 1 und ein Verfahren mit den Merkmalen des Patentanspruchs 8 gelöst. Vorteilhafte Weiterbildungen und Modifikationen sind Gegenstände der Unteransprüche.

Erfindungsgemäß ist vorgesehen, dass die Messleiste und die Kontaktfederabschnitte aus dem gleichen Werkstoff und einstückig ausgebildet sind, wobei jeder Kontaktfederabschnitt quer zur Messleisten-Erstreckungsrichtung betrachtet, schlaufenförmig oder hakenförmig ausgebildet ist und dass der Messrahmen eine mechanische Zugvorrichtung aufweist, in der die Messleiste unter Zugspannung zwischen den einander gegenüber liegenden Rahmenkantenstreben eingespannt ist.

Durch die einstückige Ausbildung der Messleiste und der Kontaktfederabschnitte sind die Messleiste und die Kontaktfederabschnitte mechanisch stabil miteinander verbunden und durch das Einspannen der Messleiste in der Zugvorrichtung unter Zugspannung wird eine mechanische Stabilität der Messleiste insbesondere beim Aufdrücken auf die Solarzellenoberfläche gewährleistet. Der Messrahmen ist bevorzugt an eine Form, Gestalt und Abmessungen üblicher Wafer-Solarzellentypen angepasst.

Weiterhin ist durch den einstückigen Aufbau von Messleiste und Kontaktfederabschnitten ein elektrisch niederohmiger Übergang zwischen diesen beiden strukturellen Abschnitten der Messleiste gewährleistet. Gleichzeitig lassen sich die Kontaktfederabschnitte materialabhängig vom zum Einsatz kommenden Werkstoff elastisch verformen. Die Befestigung der Kontaktfederabschnitte an der Messleiste weist in dieser Ausgestaltung keine mechanischen Schwachstellen wie beispielsweise eine Löt-, Klemm-, Klebe- oder Schweißverbindung auf. Dadurch ist die Vorrichtung weniger schaden- und reparaturanfällig, da die Wahrscheinlichkeit geringer ist, dass sich Kontaktfederabschnitte von der Messleiste durch intensiven Gebrauch und/oder falsche Handhabung ablösen. Zudem ist die Messleiste samt Kontaktfederabschnitte kostengünstig herstellbar, da nicht mehrere Bauteile, sondern lediglich ein Bauteil benötigt werden. Zudem lässt sich die Messleiste mit den schlaufen- oder hakenförmige ausgebildeten Kontaktfederabschnitten quer zur Messleisten-Erstreckungsrichtung betrachtet deutlich schmaler ausbilden. Auf diese Weise wird die Abschattung beim Messvorgang derart reduziert, dass eine an die realen Abmessungen eines Solarzellenstrings im Solarmodul angepasste Messung vorgenommen werden kann.

Jeder Kontaktfederabschnitt ist quer zur Messleisten-Erstreckungsrichtung betrachtet schlaufenförmig oder hakenförmig ausgebildet. Der Kontaktfederabschnitt weist bevorzugt einen Federteil und einen Kontaktteil auf. Der Federteil ist an der unteren Kante der Messleiste angeordnet, wobei sich der Federteil senkrecht oder im Wesentlichen senkrecht zur Messleisten-Erstreckungsrichtung ausgehend von der unteren Kante der Messleiste erstreckt. Die geometrisch-strukturelle Ausgestaltung des Federteils bestimmt die Federkraft, die notwendig ist, um den an den Federteil einstückig anschließenden Kontaktteil bei der Bewegung in eine Kontaktierposition elastisch zu verformen, in der der Kontaktfederabschnitt beim Aufsetzen der Messleiste auf die Solarzellenoberfläche mindestens eine Fingerelektrode durch einen federelastischen mechanischen Kontakt elektrisch kontaktiert. Die Geometrie des Kontaktteils des Kontaktfederabschnittes bestimmt die elektrische Kontaktfläche und hat ebenso Einfluss auf die für die elastische Verformung des Kontaktfederabschnittes notwendige Federkraft. Der Kontaktteil ist so ausgestaltet, dass beim Aufsetzen der Messleiste auf die Solarzellenoberfläche durch die Summe der elektrischen Kontaktflächen aller Kontaktfederabschnitte sämtliche Fingerelektroden der Solarzelle durch die Mehrzahl der Kontaktfederabschnitte elektrisch kontaktiert sind. Die frei gestaltbare, schlaufenförmige oder hakenförmige einstückige Ausbildung der Kontaktfederabschnitte ermöglicht die Kontaktierung aller Fingerelektroden mit einer ausreichenden Federkraft.

Der Federteil erstreckt sich bevorzugt von der unteren Kante der Messleiste winkelig, abgerundet gebogen, geschwungen oder eckig gekrümmt. Der Kontaktteil ist überwiegend bevorzugt parallel oder im Wesentlichen parallel zur Messleisten-Erstreckungsrichtung ausgebildet. Wenn der Kontaktteil an einem einzigen Federteil angeordnet ist, ist der Kontaktfederabschnitt hakenförmig ausgebildet, weil der Kontaktteil an seinem einen Ende über den Federteil an der Unterkante der Messleiste befestigt ist. Das andere Ende des Kontaktteils hängt frei. Der Kontaktteil kann alternativ über zwei Federteile mit der unteren Kante der Messleiste verbunden sein. Der Kontaktfederabschnitt ist dann schlaufenförmig ausgebildet, so dass zwischen dem Kontaktteil und der unteren Kante der Messleiste eine Öffnung im Material der Messleiste ausgebildet ist und der Kontaktfederabschnitt eine um diese Öffnung im Material der Messleiste herum reichende elastisch verformbare Schlaufe bildet. Dieser strukturell symmetrische Aufbau bietet den Vorteil eines gleichmäßigen Krafteintrags über den Kontaktteil auf die zu kontaktierenden Elektrodenfinger.

Der Werkstoff der Messleiste und daran angeordneten Kontaktfederabschnitten ist bevorzugt ein elektrischer leitfähiges Material bevorzugt ein Metall oder eine Metalllegierung. Das Metall oder die Metalllegierung ist bevorzugt korrosionsbeständig und weist eine gute elektrische Leitfähigkeit auf. Bei der Messleiste handelt es sich bevorzugt um ein Metallblech, aus dem die einstückig mit der Messleiste ausgebildeten Kontaktfederabschnitte in Form von Drähten herausgeschnitten und/oder herausgestanzt sind. Der Werkstoff ist bevorzugt ausgewählt aus der Gruppe, bestehend aus Kupfer und Kupferlegierungen wie Cu, CuBe2, CuZn37 und CuSn6. Das Elastizitätsmodul des Werkstoffs liegt bevorzugt im Bereich von 70000-210000 N/mm², gemessen nach DIN EN ISO 6892-1 :2017-02. Des Weiteren weist der Werkstoff bevorzugt eine Streckgrenze im Bereich von 140 - 1500 N/mm² auf, gemessen nach DIN EN ISO 6892-1:2017-02. Das Elastizitätsmodul und die Streckgrenze bestimmen die Federkraft und den maximalen Federweg der Kontaktfederabschnitte.

In einer bevorzugten Ausführungsform ist jede Messleiste als ein Metallblech mit einer Dicke im Bereich von 0,2 bis 1,5 mm, bevorzugt 0,3 bis 1,0 mm, bevorzugter 0,4 bis 0,7 mm ausgebildet. Damit ergibt sich eine deutlich geringere optische Abschattung der Solarzellenoberfläche beim Vermessen elektrischen Kenndaten einer Solarzelle.

Bevorzugt sind die Kontaktfederabschnitte als drahtartige Elemente periodisch entlang der Messleisten-Erstreckungsrichtung entlang einer unteren Kante der Messleiste angeordnet. Dadurch wird weiterhin sichergestellt, dass die Kontaktfederabschnitte alle Fingerelektroden der auszulesenden Solarzelle beim Aufsetzen der Kontaktfederabschnitte auf die Solarzellenoberfläche kontaktieren.

Der Messrahmen weist weiterhin mit Vorteil eine Einstellvorrichtung auf, mittels der die Messleiste in ihrer Höhe und ihrer Anordnung entlang der Rahmenkantenstreben verstellt werden kann. Beispielsweise weisen die Rahmenkantenstreben und/oder ein daran befestigtes Bauteil schlitzförmige Aussparungen auf, in denen das Bauteil, ein weiteres Bauteil und/oder Einstellschrauben verschiebbar angeordnet sind.

Bevorzugt weist die Vorrichtung mindestens zwei Messleisten auf, die mit ihren Messleisten-Erstreckungsrichtungen parallel zueinander angeordnet sind, wobei die mindestens zwei Messleisten als eine Kombinations-Messleiste in die Zugvorrichtung eingespannt sind. D.h., die mindestens zwei Messleisten sind zu einer kombinierten Messleiste zusammengefasst. Die beiden Messleisten sind in einer Ausführungsform zueinander elektrisch isoliert angeordnet. Die elektrische Isolierung ist beispielsweise durch eine elektrisch hinreichend isolierende Folie oder durch Papier realisiert, die oder das jeweils zwischen den mindestens zwei Messleisten flächig angeordnet ist. Noch bevorzugter weist die Vorrichtung mindestens drei Messleisten auf, die mit ihren Messleisten-Erstreckungsrichtungen parallel zueinander angeordnet und gegeneinander elektrisch isoliert sind, wobei die drei Messleisten als eine Kombinations-Messleiste in die Zugvorrichtung eingespannt sind. Dadurch lässt sich insbesondere die in der Solarzellen-Charakterisierung übliche 4-Leiter-Messtechnik zum Auslesen der elektrischen Kenndaten der Solarzelle realisieren.

Unter dem Ausdruck "4-Leiter-Messtechnik" ist eine 4-Punkt-Kontaktierung zu verstehen. Diese Messtechnik wird üblicherweise zur Messung kleiner Widerstände verwendet, um den Widerstand der Zuleitungen zu eliminieren. Damit kann eine separate Messung von Strom (I) und Spannung (U) erfolgen. Zur Messung sind die Messleisten gegeneinander elektrisch isoliert und als eine Kombinations-Messleiste in eine Zugvorrichtung eingespannt. Im Falle von drei Messleisten können beispielsweise die zwei äußeren Messleisten für die Stromabfuhr zuständig sein, wobei sie derart versetzt eingespannt sind, dass quer zur Messleisten-Erstreckungsrichtung betrachtet die Kontaktfederabschnitte nicht fluchtend, sondern versetzt zueinander angeordnet sind. Dadurch wird eine redundante elektrische Kontaktfläche auf der Solarzellenoberfläche realisiert. Die sich zwischen den beiden äußeren Strom-Messleisten befindende innere Messleiste wird zur Messung der Spannung genutzt. Damit wird eine IUI-Messgeometrie bereitgestellt, mit der Messfehler in der 4-Leiter-Messtechnik reduziert werden können. Neben dieser beispielhaften Schilderung der Bereitstellung der IUI-Messgeometrie können bei Verwendung der mindestens drei Messleisten analog auch andere bevorzugte Messgeometrien wie IIU, IUIU, IUIUI bereitgestellt werden. Durch diese Messgeometrien können Messfehler weiterhin reduziert werden.

Wie vorangehend beschrieben weisen zwei der parallel eingespannten Messleisten senkrecht zur Messleisten-Erstreckungsrichtung betrachtet bevorzugt zueinander versetzt angeordnete Kontaktfederabschnitte auf. Damit wird sichergestellt, dass die Summe der Kontaktfederabschnitte alle Fingerelektroden der auszulesenden Solarzelle beim Aufsetzen der Kontaktfederabschnitte auf die Solarzellenoberfläche gut kontaktieren und nicht einige Fingerelektroden in Bereichen zwischen zwei Kontaktfederabschnitten nicht oder nicht hinreichend elektrisch kontaktiert sind.

In einer bevorzugten Ausführungsform sind die Kontaktfederabschnitte aus der Messleiste lasergeschnitten und/oder ausgestanzt. D.h., die Messleiste samt der Kontaktfederabschnitte ist aus einem Metallblech direkt herstellbar. Dadurch wird eine kostengünstige Herstellung der Messleisten und damit der Vorrichtung erzielt. Zudem sind maßgeschneiderte Designs der Kontaktfederabschnitte in Hinsicht auf strukturelle Geometrie von Federteil und Kontaktteil und die realisierte elastische Federkraft mittels Laserschneidens einfach und vergleichsweise kostengünstig zu fertigen.

Die Erfindung betrifft ferner ein Verfahren zur Messung elektrischer Kenndaten einer Solarzelle, aufweisend folgende Schritte:
- Bereitstellen einer Vorrichtung gemäß einer oder mehreren der vorangehend beschriebenen Ausführungsformen mit einer Mehrzahl von Messleisten,
- Bereitstellen einer zu vermessenden Solarzelle mit einer Solarzellenoberfläche und auf der Solarzellenoberfläche angeordneter Fingerelektroden und Bereitstellen einer Solarzellentestvorrichtung,
- mechanisches Kontaktieren der Fingerelektroden auf der Solarzellenoberfläche mit den Kontaktfederabschnitten der Messleisten,
- Aussenden eines Lichtblitzes auf die Solarzellenoberfläche,
- Abgreifen eines durch den Lichtblitz generierten, durch die Fingerelektroden fließenden elektrischen Stroms mittels der Kontaktfederabschnitte der einen Messleiste und
- Abgreifen einer elektrischen Spannung als Messsignal über die Kontaktfederabschnitte der anderen Messleiste, und
- Vermessen und Auswerten des abgegriffenen elektrischen Stroms und Vermessen der abgegriffenen elektrischen Spannung mittels der Solarzellentestvorrichtung.

Zu der Vorrichtung gemachte Ausführungen und/oder beschriebene Vorteile gelten für das Verfahren entsprechend und umgekehrt.

Bevorzugt werden eine Anzahl der Messleisten und deren Positionierung auf der Solarzellenoberfläche der zu vermessenden Solarzelle derart gewählt, dass die Anzahl und die Position der Messleisten Anzahl und Position von Zellverbindern zwischen zwei zu einem Solarzellenstring zu verschaltenden Solarzellen in einem Solarmodul entsprechen. Dadurch können die Messleisten die Zellverbinder und deren generierte Abschattung simulieren. Dadurch wird eine Vermessung und Auswertung der elektrischen Kenndaten der Solarzelle ermöglicht, die der Einbausituation in einem Solarmodul weitgehend entspricht.

In einer weiterhin bevorzugten Ausführungsform wird die Dicke der Messleisten quer zur Messleisten-Erstreckungsrichtung betrachtet der Dicke der Zellverbinder entsprechend ausgewählt, die in einem Solarmodul zum Einsatz kommen, das aufgebaut werden soll aus einer Mehrzahl der zu vermessenden Solarzellen, die in diesem Solarmodul zu einem Solarzellenstring verschaltet werden. Dadurch werden eine noch realitätsnähere Vermessung und Auswertung der elektrischen Kenndaten der Solarzelle ermöglicht.

Bevorzugt ist jede Messleiste als Kombinations-Messleiste aus mindestens drei gegeneinander elektrisch isolierten Messleisten ausgebildet, die parallel zueinander angeordnet sind, wobei mindestens zwei der Messleisten zur Messung des durch den Lichtblitz generierten, durch die Fingerelektroden fließenden elektrischen Stroms genutzt werden und mindestens eine der Messleisten zur Messung der durch den Lichtblitz generierten elektrischen Spannung genutzt wird. Hierdurch wird die vorstehend beschriebene 4-Leiter-Messung samt ihren vorstehend beschriebenen Vorteilen realisiert.

Verschiedene Ausführungsbeispiele der Erfindung sind in den Zeichnungen rein schematisch dargestellt und werden nachfolgend näher beschrieben. Es zeigt schematisch und nicht maßstabsgerecht
- Fig. 1: eine perspektivische Ansicht einer erfindungsgemäßen Vorrichtung; und
- Fig. 2a bis 2e: jeweils eine Draufsicht auf unterschiedliche Ausführungsformen von Messleisten und Kombinations-Messleisten.

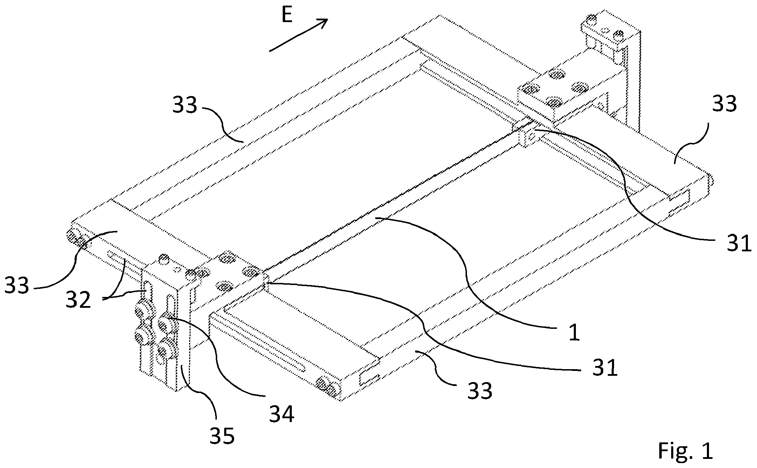

Fig. 1 zeigt eine perspektivische Ansicht einer erfindungsgemäßen Vorrichtung zur elektrischen Kontaktierung einer Solarzelle (nicht gezeigt) bei der Messung elektrischer Kenndaten der Solarzelle, die eine Vielzahl von Fingerelektroden auf einer Solarzellenoberfläche aufweist. Die Vorrichtung weist eine Messleiste 1 auf. Die Messleiste 1 erstreckt sich zwischen zwei Messleisten-Endabschnitten entlang einer Messleisten-Erstreckungsrichtung E. Die Messleiste 1 weist mindestens einen Kontaktanschluss (nicht gezeigt) zur elektrischen Kontaktierung mit einer Solarzellentestvorrichtung (nicht gezeigt) auf.

Die Vorrichtung weist weiterhin einen Messrahmen 3 mit einander gegenüber liegenden Rahmenkantenstreben 33 auf, der mit den Rahmenkantenstreben 33 eine Fläche größer gleich einer zu vermessenden Solarzelle (nicht gezeigt) umgreift. Der Messrahmen 3 weist eine mechanische Zugvorrichtung 31 auf, in der die Messleiste 1 unter Zugspannung zwischen einander gegenüber liegenden Rahmenkantenstreben 33 eingespannt sind. Dazu weist die mechanische Zugvorrichtung 31 eine Einspannvorrichtung auf, in der die Messleiste 1 eingespannt ist. Der Messrahmen 3 weist ferner eine Einstellvorrichtung 35 mit Einstellschrauben 34 auf, mittels denen sich weiterhin insbesondere eine Höheneinstellung der Messleiste 1 in Bezug zu den Rahmenkantenstreben 33 in dem Messrahmen 3 einstellen lassen. Die Einstellvorrichtung 35 und die Einstellschrauben 34 sind dazu in schlitzförmigen Langlöchern 32 verschiebbar.

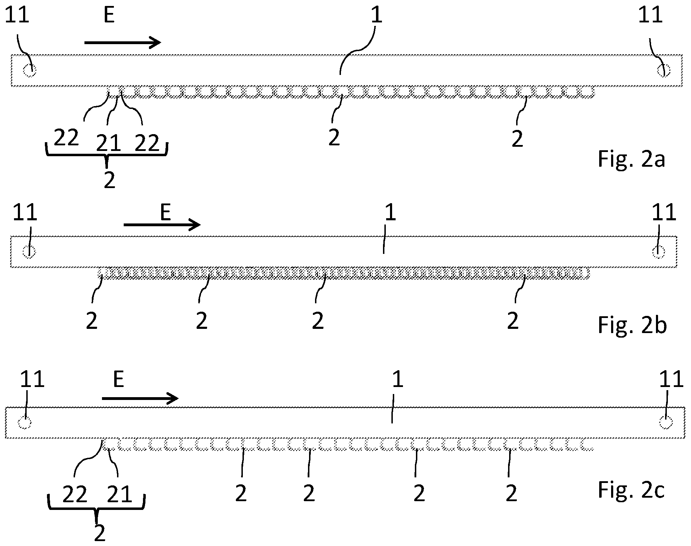

Eine Mehrzahl von Kontaktfederabschnitten 2 ist entlang der Messleisten-Erstreckungsrichtung E an der unteren Kante der Messleiste 1 angeordnet. Dies ist in den Figuren 2a bis 2e im Detail gezeigt. Jeder Kontaktfederabschnitt ist 2 ausgebildet, beim Aufsetzen der Messleiste 1 auf die Solarzellenoberfläche, mit der Messleisten-Erstreckungsrichtung E quer zu den Fingerelektroden orientiert mindestens eine Fingerelektrode durch einen federelastischen mechanischen Kontakt elektrisch zu kontaktieren. Die Messleiste 1 ist mit den Kontaktfederabschnitte 2 aus dem gleichen Werkstoff ausgebildet und die Messleiste 1 ist mit den an ihrer Unterkante angeordneten Kontaktfederabschnitten 1 einstückig ausgebildet. Jeder Kontaktfederabschnitt 2 ist quer zur Messleisten-Erstreckungsrichtung E betrachtet schlaufenförmig oder hakenförmig ausgebildet.

Bei Betrieb der Vorrichtung wird die zu vermessende Solarzelle (nicht gezeigt) mit einer Solarzellenoberfläche und auf der Solarzellenoberfläche angeordneten Fingerelektroden bereitgestellt und eine Solarzellentestvorrichtung (nicht gezeigt) bereitgestellt, die mit der Messleiste 1 verbunden ist. Die Fingerelektroden auf der Solarzellenoberfläche werden mit den Kontaktfederabschnitten 2 der Messleiste 1 kontaktiert. Ein Lichtblitz wird auf die Solarzellenoberfläche ausgesendet. Ein durch den Lichtblitz generierten, durch die Fingerelektroden fließender elektrischer Strom wird mittels der Kontaktfederabschnitte 2 der einen Messleiste 1 abgegriffen und eine elektrische Spannung wird als Messsignal über die Kontaktfederabschnitte 2 einer weiteren Messleiste (nicht gezeigt) abgegriffen. Der abgegriffene elektrische Strom und die abgegriffene elektrische Spannung werden mittels der Solarzellentestvorrichtung vermessen und ausgewertet.

Fig. 2a bis 2e zeigen jeweils eine Draufsicht auf unterschiedliche Ausführungsformen von Messleisten und Kombinations-Messleisten, die in der in Fig. 1 gezeigten Vorrichtung einsetzbar sind.

Fig. 2a zeigt eine Draufsicht auf eine Messleiste quer zur Messleisten-Erstreckungsrichtung E betrachtet. Die Messleiste 1 weist zwei Fixieröffnungen 11 auf. Mittels der Fixieröffnungen 11 kann die Messleiste 1 in der in Fig. 1 gezeigten mechanischen Zugvorrichtung 31 fixiert werden. Die Messleiste 1 weist die Mehrzahl an Kontaktfederabschnitten 2 auf, die als drahtartige Elemente periodisch entlang der Messleisten-Erstreckungsrichtung E entlang der unteren Kante der Messleiste 1 benachbart zueinander angeordnet sind. Jeder Kontaktfederabschnitt 2 weist zwei Federteile 22 auf, die ausgehend von der unteren Kante der Messleiste 1 quer zu ihr angeordnet sind und die durch einen Kontaktteil 21 miteinander verbunden sind. Dadurch ist jeder Kontaktfederabschnitt 2 quer zur Messleisten-Erstreckungsrichtung E betrachtet schlaufenförmig ausgebildet.

Fig. 2b zeigt eine Draufsicht auf eine Kombinations-Messleiste, gebildet aus zwei Messleisten 1 gemäß Figur 2a. Zwei identische Messleisten 1 sind entlang ihrer Messleisten-Erstreckungsrichtungen E parallel zueinander jedoch derart versetzt angeordnet, dass die Kontaktfederabschnitte 2 nicht bündig fluchtend, sondern versetzt zueinander angeordnet sind. Die beiden Messleisten 1 können gegeneinander elektrisch isoliert montiert sein.

Fig. 2c zeigt eine Draufsicht auf eine weitere Ausführungsform einer Messleiste quer zur Messleisten-Erstreckungsrichtung E betrachtet. Die in Fig. 2c gezeigte Messleiste 1 entspricht der in Fig. 2a gezeigten Messleiste mit dem Unterschied, dass jeder Kontaktfederabschnitt 2 quer zur Messleisten-Erstreckungsrichtung E betrachtet hakenförmig und nicht schlaufenförmig ausgebildet ist. Jeder Kontaktfederabschnitt 2 weist nur einen einziges Federteil 22 auf, das mit jeweils einem sich von der unteren Kante der Messleiste erstreckenden Kontaktteil 21 verbunden ist.

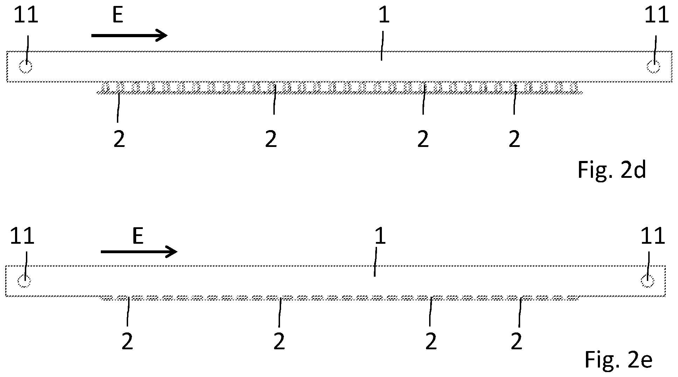

Fig. 2d zeigt eine Draufsicht auf eine weitere Kombinations-Messleiste gebildet aus zwei Messleisten 1 gemäß Figur 2a. Zwei identische Messleisten 1 sind entlang ihrer Messleisten-Erstreckungsrichtungen E parallel zueinander jedoch derart versetzt angeordnet, dass die Kontaktfederabschnitte 2 nicht bündig fluchtend, sondern versetzt zueinander angeordnet sind. Die beiden Messleisten 1 können gegeneinander elektrisch isoliert montiert sein.

Fig. 2e zeigt eine Draufsicht auf eine weitere Ausführungsform einer Messleiste quer zur Messleisten-Erstreckungsrichtung E betrachtet. Die in Fig. 2e gezeigte Messleiste 1 entspricht der in Fig. 2a gezeigten Messleiste mit dem Unterschied, dass die Kontaktfederabschnitte 2 durch in der unteren Kante der Messleiste angeordnete Schlitzlöcher gebildet sind. Dadurch ist die Schlaufe der schlaufenförmigen Kontaktfederabschnitte 2 wesentlich kleiner als die in Fig. 2a gezeigte Schlaufe.

### Bezugszeichenliste:

- E: Messleisten-Erstreckungsrichtung
- 1: Messleiste
- 11: Fixieröffnung
- 2: Kontaktfederabschnitt
- 21: Kontaktteil
- 22: Federteil
- 3: Messrahmen
- 31: mechanische Zugvorrichtung
- 32: Langlöcher
- 33: Rahmenkantenstrebe
- 34: Einstellschrauben
- 35: Einstellvorrichtung

## Patentansprüche

1. Vorrichtung zur elektrischen Kontaktierung einer Solarzelle bei der Messung elektrischer Kenndaten der Solarzelle, wobei die Solarzelle mit einer Vielzahl von Fingerelektroden auf einer Solarzellenoberfläche ausgebildet ist, die Vorrichtung aufweisend
- mindestens eine Messleiste (1), die sich zwischen zwei Messleisten-Endabschnitten in einer Messleisten-Erstreckungsrichtung (E) erstreckt, wobei die Messleiste (1) mindestens einen Kontaktanschluss zur elektrischen Kontaktierung mit einer Solarzellentestvorrichtung aufweist,
- eine Mehrzahl von Kontaktfederabschnitten (2), die entlang der Messleisten-Erstreckungsrichtung (E) an der Messleiste (1) angeordnet sind, wobei jeder Kontaktfederabschnitt (2) ausgebildet ist, beim Aufsetzen der Messleiste (1) auf die Solarzellenoberfläche, mit der Messleisten-Erstreckungsrichtung (E) quer zu den Fingerelektroden orientiert mindestens eine Fingerelektrode durch einen federelastischen mechanischen Kontakt elektrisch zu kontaktieren und
- einen Messrahmen (3) mit einander gegenüber liegenden Rahmenkantenstreben (33), der mit den Rahmenkantenstreben (33) eine Fläche größer gleich einer zu vermessenden Solarzelle umgreift, wobei die Messleiste (1) und die Kontaktfederabschnitte (2) aus dem gleichen Werkstoff und einstückig ausgebildet sind, wobei jeder Kontaktfederabschnitt (2) quer zur Messleisten-Erstreckungsrichtung (E) betrachtet schlaufenförmig oder hakenförmig ausgebildet ist,
**dadurch gekennzeichnet, dass** der Messrahmen (3) eine mechanische Zugvorrichtung (31) aufweist, in der die Messleiste (1) unter Zugspannung zwischen den einander gegenüber liegenden Rahmenkantenstreben (33) eingespannt ist.

2. Vorrichtung nach Anspruch 1, **dadurch gekennzeichnet, dass** jede Messleiste (1) als ein Metallblech mit einer Dicke im Bereich von 0,2 bis 1,5 mm, bevorzugt 0,3 bis 1,0 mm, bevorzugter 0,4 bis 0,7 mm ausgebildet ist.

3. Vorrichtung nach Anspruch 1 oder 2, **dadurch gekennzeichnet, dass** die Kontaktfederabschnitte (2) als drahtartige Elemente periodisch entlang der Messleisten-Erstreckungsrichtung (E) entlang einer unteren Kante der Messleiste (1) angeordnet sind.

4. Vorrichtung nach einem der vorangehenden Ansprüche, **gekennzeichnet durch** mindestens zwei Messleisten (1), die mit ihren Messleisten-Erstreckungsrichtungen (E) parallel zueinander angeordnet sind und wobei die mindestens zwei Messleisten (1) als eine Kombinations-Messleiste in die mechanische Zugvorrichtung (31) eingespannt sind.

5. Vorrichtung nach Anspruch 4, **dadurch gekennzeichnet, dass** die mindestens zwei Messleisten (1) gegeneinander elektrisch isoliert angeordnet sind.

6. Vorrichtung nach Anspruch 4 oder 5, **dadurch gekennzeichnet, dass** zwei der parallel eingespannten Messleisten (1) senkrecht zur Messleisten-Erstreckungsrichtung (E) betrachtet zueinander versetzt angeordnete Kontaktfederabschnitte (2) aufweisen.

7. Vorrichtung nach einem der vorangehenden Ansprüche, **dadurch gekennzeichnet, dass** die Kontaktfederabschnitte (2) aus der Messleiste (1) lasergeschnitten und/oder ausgestanzt sind.

8. Verfahren zur Messung elektrischer Kenndaten einer Solarzelle, aufweisend folgende Schritte:
- Bereitstellen einer Vorrichtung nach einem der vorangehenden Ansprüche 1 bis 7 mit einer Mehrzahl von Messleisten (1),
- Bereitstellen einer zu vermessenden Solarzelle mit einer Solarzellenoberfläche und auf der Solarzellenoberfläche angeordneten Fingerelektroden und
- Bereitstellen einer Solarzellentestvorrichtung,
- mechanisches Kontaktieren der Fingerelektroden auf der Solarzellenoberfläche mit den Kontaktfederabschnitten (2) der Messleisten (1),
- Aussenden eines Lichtblitzes auf die Solarzellenoberfläche,
- Abgreifen eines durch den Lichtblitz generierten, durch die Fingerelektroden fließenden elektrischen Stroms mittels der Kontaktfederabschnitte (2) der einen Messleiste (1) und
- Abgreifen einer elektrischen Spannung als Messsignal über die Kontaktfederabschnitte (2) der anderen Messleiste (1), und
- Vermessen und Auswerten des abgegriffenen elektrischen Stroms und Vermessen der abgegriffenen elektrischen Spannung mittels der Solarzellentestvorrichtung.

9. Verfahren nach Anspruch 8, **dadurch gekennzeichnet, dass** eine Anzahl der Messleisten (1) und deren Positionierung auf der Solarzellenoberfläche der zu vermessenden Solarzelle derart gewählt wird, dass die Anzahl und die Position der Messleisten (1) Anzahl und Position von Zellverbindern zwischen zwei zu einem Solarzellenstring zu verschaltenden Solarzellen entspricht.

10. Verfahren nach Anspruch 9, **dadurch gekennzeichnet, dass** die Dicke der Messleisten quer zur Messleisten-Erstreckungsrichtung (E) betrachtet der Dicke der Zellverbinder entsprechend ausgewählt wird, die in einem Solarmodul zum Einsatz kommen, das aufgebaut werden soll aus einer Mehrzahl der zu vermessenden Solarzellen, die in diesem Solarmodul zu einem Solarzellenstring verschaltet werden.

11. Verfahren nach einem der Ansprüche 9 oder 10, **dadurch gekennzeichnet, dass** jede Messleiste (1) als Kombinations-Messleiste aus mindestens drei gegeneinander elektrisch isolierten Messleisten (1) ausgebildet ist, die parallel zueinander angeordnet sind, wobei mindestens zwei der Messleisten (1) zur Messung des durch den Lichtblitz generierten, durch die Fingerelektroden fließenden elektrischen Stroms genutzt werden und mindestens eine der Messleisten (1) zur Messung der durch den Lichtblitz generierten elektrischen Spannung genutzt wird.

## Claims

1. A device for electrically contacting a solar cell during the measurement of electrical characteristics of the solar cell, wherein the solar cell is embodied with a multiplicity of finger electrodes on a solar cell surface, the device comprising
- at least one measuring strip (1) extending between two measuring strip end sections in a measuring strip extension direction (E), wherein the measuring strip (1) has at least one contact terminal for electrical contacting with a solar cell test device,
- a plurality of contact spring sections (2) arranged on the measuring strip (1) along the measuring strip extension direction (E), wherein each contact spring section (2) is configured to electrically contact at least one finger electrode by spring-elastic mechanical contact when the measuring strip (1) is placed onto the solar cell surface, with the measuring strip extension direction (E) oriented transversely with respect to the finger electrodes, and
- a measuring frame (3) having frame edge struts (33) situated opposite one another, which, with the frame edge struts (33), engages around an area that is greater than or equal to a solar cell to be measured,
wherein
the measuring strip (1) and the contact spring sections (2) are embodied from the same material and integrally, wherein each contact spring section (2) is embodied in a looped or hooked fashion as viewed transversely with respect to the measuring strip extension direction (E), **characterized in that** the measuring frame (3) has a mechanical tension device (31), in which the measuring strip (1) is clamped under tensile stress between the frame edge struts (33) situated opposite one another.

2. The device as claimed in claim 1, **characterized in that** each measuring strip (1) is embodied as a metal sheet having a thickness in the range of 0.2 to 1.5 mm, preferably 0.3 to 1.0 mm, more preferably 0.4 to 0.7 mm.

3. The device as claimed in claim 1 or 2, **characterized in that** the contact spring sections (2) are arranged as wire-like elements periodically along the measuring strip extension direction (E) along a lower edge of the measuring strip (1).

4. The device as claimed in any of the preceding claims, **characterized by** at least two measuring strips (1) arranged with their measuring strip extension directions (E) parallel to one another, and wherein the at least two measuring strips (1) are clamped as a combination measuring strip into the mechanical tension device (31).

5. The device as claimed in claim 4, **characterized in that** the at least two measuring strips (1) are arranged in a manner electrically insulated from one another.

6. The device as claimed in claim 4 or 5, **characterized in that** two of the measuring strips (1) clamped parallel have contact spring sections (2) arranged offset with respect to one another as viewed perpendicular to the measuring strip extension direction (E).

7. The device as claimed in any of the preceding claims, **characterized in that** the contact spring sections (2) are laser-cut and/or stamped from the measuring strip (1).

8. A method for measuring electrical characteristics of a solar cell, comprising the following steps:
- providing a device as claimed in any of the preceding claims 1 to 7 having a plurality of measuring strips (1),
- providing a solar cell to be measured having a solar cell surface and finger electrodes arranged on the solar cell surface, and
- providing a solar cell test device,
- mechanically contacting the finger electrodes on the solar cell surface with the contact spring sections (2) of the measuring strips (1),
- emitting a flash of light at the solar cell surface,
- tapping off an electric current that is generated by the flash of light and flows through the finger electrodes by means of the contact spring sections (2) of one measuring strip (1) and
- tapping off an electrical voltage as a measurement signal by way of the contact spring sections (2) of the other measuring strip (1), and
- measuring and evaluating the tapped-off electric current and measuring the tapped-off electrical voltage by means of the solar cell test device.

9. The method as claimed in claim 8, **characterized in that** a number of the measuring strips (1) and the positioning thereof on the solar cell surface of the solar cell to be measured are chosen in such a way that the number and the position of the measuring strips (1) correspond to the number and position of cell connectors between two solar cells to be interconnected to form a solar cell string.

10. The method as claimed in claim 9, **characterized in that** the thickness of the measuring strips as viewed transversely with respect to the measuring strip extension direction (E) is chosen so as to correspond to the thickness of the cell connectors used in a solar module that is intended to be constructed from a plurality of the solar cells to be measured which are interconnected to form a solar cell string in said solar module.

11. The method as claimed in either of claims 9 and 10, **characterized in that** each measuring strip (1) is embodied as a combination measuring strip composed of at least three measuring strips (1) which are electrically insulated from one another and which are arranged parallel to one another, wherein at least two of the measuring strips (1) are used for measuring the electric current that is generated by the flash of light and flows through the finger electrodes, and at least one of the measuring strips (1) is used for measuring the electrical voltage generated by the flash of light.

## Revendications

1. Un dispositif de contact électrique d'une cellule solaire dans la mesure des caractéristiques électriques de la cellule solaire, dans lequel la cellule solaire est formée avec une pluralité d'électrodes de doigt sur une surface de cellule solaire, le dispositif ayant
- au moins une barre de mesure (1) s'étendant entre deux sections d'extrémité de la barre de mesure dans le sens d'extension de la barre de mesure (E), la barre de mesure (1) ayant au moins une connexion de contact pour le contact électrique avec un dispositif de test de cellule solaire,
- une pluralité de sections de ressort de contact (2) disposées le long du sens d'extension de la barre de mesure (E) sur la barre de mesure (1), chaque section de ressort de contact (2) étant formée de contacter au moins une électrode de doigt au moyen d'un contact mécanique élastique à ressort, lorsque la barre de mesure (1) est placée à la surface de la cellule solaire, le sens d'extension de la barre de mesure (E) étant orienté transversalement aux électrodes de doigts, et
- un cadre de mesure (3) avec des entretoises de bord opposées (33), qui englobe une surface supérieure à égale à une cellule solaire à mesurer avec les entretoises de bord du cadre (33),
dans lequel
la barre de mesure (1) et les sections de ressort de contact (2) sont constituées du même matériau et sont constituées d'une seule pièce, chaque section de ressort de contact (2) étant en forme de boucle ou de crochet vue transversalement par rapport au sens d'extension de la barre de mesure (E) caractérisé en que le cadre de mesure (3) a un dispositif mécanique de traction (31) dans lequel la barre de mesure (1) est serrée sous contrainte de traction entre les entretoises de bord du cadre opposées (33).

2. Un dispositif selon la revendication 1, **caractérisé en ce que** chaque barre de mesure (1) est formée comme une feuille métallique ayant une épaisseur comprise entre 0,2 et 1,5 mm, de préférence 0,3 à 1,0 mm, plus préférentiellement 0,4 à 0,7 mm.

3. Un dispositif selon la revendication 1 ou 2, **caractérisé en ce que** les sections de ressort de contact (2) sont périodiquement disposées en éléments filaires le long de la direction d'extension de la barre de mesure (E) le long d'un bord inférieur de la barre de mesure (1).

4. Un dispositif selon des revendications précédentes, **caractérisé par** au moins deux barres de mesure (1) disposées parallèlement l'une à l'autre avec leurs sens d'extension de la barre de mesure (E) et les au moins deux barres de mesure (2) étant serrées dans le dispositif de tension mécanique ( 31) en tant que barres de mesure combinées (31).

5. Un dispositif selon la revendication 4, **caractérisé en ce que** les au moins deux barres de mesure (1) sont isolées électriquement l'une de l'autre.

6. Un dispositif selon la revendication 4 ou 5, **caractérisé en ce que** deux des barres de mesure (1) serrées en parallèle présentent des sections de ressort de contact (2) déplacées l'une de l'autre lorsqu'elles sont vues perpendiculairement à la direction d'extension de la barre de mesure (E).

7. Un dispositif selon l'une des revendications précédentes, **caractérisé en ce que** les sections de ressort de contact (2) sont découpées au laser et/ou perforées hors de la barre de mesure(1).

8. Un procédé de mesure des caractéristiques électriques d'une cellule solaire, comprenant les étapes suivantes :
- fournir un dispositif selon l'une quelconque des revendications 1 à 7 précédentes avec une pluralité de barres de mesure (1),
- fournir une cellule solaire à mesurer avec une surface de cellule solaire et des électrodes de doigts disposés sur la surface de la cellule solaire, et
- fournir un dispositif de test de cellules solaires,
- contacter mécaniquement les électrodes de doigts à la surface de la cellule solaire avec les sections de ressort de contact (2) des barres de mesure (1),
- envoyer un flash de lumière à la surface de la cellule solaire,
- capter un courant électrique généré par le flash de lumière circulant à travers les électrodes de doigts au moyen des sections de ressort de contact (2) d'une barre de mesure (1) et
- capter une tension électrique comme signal de mesure via les sections de ressort de contact (2) de l'autre barre de mesure (1), et
- mesurer et évaluer le courant électrique capté et mesurer la tension électrique captée au moyen du dispositif de test de la cellule solaire.

9. Un procédé selon la revendication 8, **caractérisé en ce qu'**un certain nombre de barres de mesure (1) et leur positionnement sur la surface de la cellule solaire de la cellule solaire à mesurer est choisi de telle sorte que le nombre et la position des barres de mesure (1) correspondent au nombre et à la position des connecteurs de cellule entre deux cellules solaires à interconnecter pour former un string de cellules solaires.

10. Un procédé selon la revendication 9, **caractérisé en ce que** l'épaisseur des barres de mesure vue transversalement au sens d'extension de la barre de mesure (E) est choisie en fonction de l'épaisseur des connecteurs de cellule utilisés dans un module solaire à construire à partir d'une pluralité de cellules solaires à mesurer, qui sont interconnectées dans ce module solaire pour former un string de cellules solaires.

11. Un procédé selon l'une des revendications 9 ou 10, **caractérisée en ce que** chaque barre de mesure (1) est conçue comme une barre de mesure combinée composée d'au moins trois barres de mesure (1) isolées électriquement qui sont disposées parallèlement les unes aux autres, au moins deux des barres de mesure (1) étant utilisées pour mesurer le courant électrique généré par le flash de lumière circulant à travers les électrodes de doigts et au moins une des barres de mesure (1) étant utilisée pour mesurer la tension électrique générée par le flash de lumière.
